# EUROPEAN PATENT APPLICATION

(11) **EP 2 597 489 A1**
(43) Date of publication of application: **29.05.2013**
(21) Application number: 11809675.9
(22) Date of filing: 20.07.2011
(51) Int. Cl.: G01T 1/20, C09K 11/00, G01T 1/202, C09K 11/06, C09K 11/80

(54) **RADIATION DETECTOR**

(30) Priority: 21.07.2010 JP 2010164360
(71) Applicant: Hiroshima University, Hiroshima 739-8511 (JP); Tokuyama Corporation, Shunan-shi, Yamaguchi-ken 745-8648 (JP); Tohoku University, Aoba-ku Sendai-shi Miyagi 980-8577 (JP)
(72) Inventor: TAKAHASHI, Hiromitsu, Higashi-Hiroshima-shi Hiroshima 739-8511 (JP); YONETANI, Mitsuo, Higashi-Hiroshima-shi Hiroshima 739-8511 (JP); MATSUOKA, Masayuki, Higashi-Hiroshima-shi Hiroshima 739-8511 (JP); FUKAZAWA, Yasushi, Higashi-Hiroshima-shi Hiroshima 739-8511 (JP); KAWAGUCHI, Noriaki, Shunan-shi Yamaguchi 745-8648 (JP); FUKUDA, Kentaro, Shunan-shi Yamaguchi 745-8648 (JP); SUYAMA, Toshihisa, Shunan-shi Yamaguchi 745-8648 (JP); YOSHIKAWA, Akira, Sendai-shi Miyagi 980-8577 (JP); YANAGIDA, Takayuki, Sendai-shi Miyagi 980-8577 (JP); YOKOTA, Yui, Sendai-shi Miyagi 980-8577 (JP); FUJIMOTO, Yutaka, Sendai-shi Miyagi 980-8577 (JP)
(74) Representative: Jackson, Martin Peter
(86) International application number: PCT/JP2011/066485
(87) International publication number: WO 2012/011505

(57) **Abstract**

[Problems to be Solved] A radiation detector, which is improved in the detection efficiency of a photodetector for light emitted by a scintillator, which has excellent long-term operational stability, and which is excellent in time resolution and count rate characteristics, is provided with the use of the scintillator with a short fluorescence lifetime.

[Means to Solve the Problems] A radiation detector is constructed by installing an optical wavelength conversion layer, which is composed of, for example, an organic fluorescent substance using polyvinyl toluene as a base material, between a scintillator composed of a fluoride single crystal, such as a Ce-containing LiCaAlF₆ crystal, and a photodetector having a light entrance window material composed of a transparent glass material such as borosilicate glass. In the radiation detector, the peak wavelength of light emitted by the scintillator is 360 nm or less, and the peak wavelength of light after conversion by the optical conversion layer is 400 nm or more. Preferably, the refractive indexes of the scintillator and the optical wavelength conversion layer are both 1.35 to 1.65.

## Description

### Technical Field:

This invention relates to a radiation detector equipped with a scintillator. More specifically, the invention relates to a radiation detector which is excellent in time resolution and count rate characteristics, which has long-term operational stability, and which can be used preferably in medical fields such as tomography, industrial fields such as nondestructive inspection, security fields such as inspection of personal belongings, and academic fields such as high energy physics.

### Background Art:

Scintillators are substances which, when hit by radiation such as alpha rays, beta rays, gamma rays, X rays, or neutrons, absorb the radiation to generate fluorescence. The scintillator in combination with a photodetector, such as a photomultiplier tube, can constitute a radiation detector.
Such a radiation detector has wide varieties of application fields, including medical fields such as tomography, industrial fields such as nondestructive inspection, security fields such as inspection of personal belongings, and academic fields such as high energy physics.

By using a scintillator with a short fluorescence lifetime as the above scintillator, the time resolution and count rate characteristics of the radiation detector are improved.
As shown in Non-Patent Document 1, fluorescence lifetime (decay time constant of fluorescence: τ) is proportional to the cube of light emission wavelength (λₑₘ). Thus, the shorter the light emission wavelength, the shorter the fluorescence lifetime tends to become. With the scintillator having a particularly short fluorescence lifetime, its light emission wavelength is frequentlyobservedtobe 360 nmor less (Non-Patent Document 1).
Among photodetectors, which detect light emitted from a scintillator and convert it into an electrical signal, are photomultiplier tubes and silicon photodiodes. However, the detection efficiency of the photodetector for light is wavelength-dependent, and the common photodetector has a high detection efficiency for light with a wavelength of 400 nm or more.

In detecting light, which has been emitted from a scintillator with a short fluorescence lifetime and a short light emission wavelength, with the use of a common photodetector, therefore, the problem has occurred that the detection efficiency decreases markedly.
In view of the above problem, a proposal has been made for a radiation detector having an optical wavelength conversion layer formed between a photodetector and a scintillator composed of cesium iodide (CsI) having a short fluorescence lifetime and a short light emission wavelength, the optical wavelength conversion layer being composed of an organic fluorescent substance using an organosilicon compound as a base material (Non-Patent Document 2). This radiation detector can convert light of about 310 nm emitted from the scintillator into light of about 400 nmby the optical wavelength conversion layer. Thus, the detection efficiency of the photodetector is increased.

### Prior Art Documents:

### Non-Patent Documents:

Non-Patent Document 1: Pieter Dorenbos, "Light output and energy resolution of Ce3+-doped scintillators", Nuclear Instruments and Methods in Physics Research, A486 (2002) 208-213 Non-Patent Document 2: L.A. Andryustchenko et al., "Functional possibilities of organosilicon coatings on the surface of Csl-based scintillator", Nuclear Instruments and Methods in Physics Research, A 486 (2002) 40-47

### Summary of the Invention:

### Problems to be solved by the invention:

With the above-described radiation detector, CsI constituting the scintillator is so hygroscopic that its environmental resistance is problematical. The optical wavelength conversion layer, therefore, needs to have not only its inherent optical wavelength conversion function, but also the function of a protective film for shielding the scintillator from the moisture. This has imposed limitations on the selection of the optical wavelength conversion layer.
Moreover, the optical wavelength conversion layer having the organosilicon compound as its base material, which is used in the radiation detector, has insufficient chemical stability, thus having posed a problem about its long-term operational stability.

The present invention has been accomplished in the light of the problems mentioned above. It is an obj ect of the invention to provide a radiation detector excellent in time resolution and count rate characteristics with the use of a scintillator with a short fluorescence lifetime. It is another object of the invention to provide a radiation detector having long-term operational stability while improving an efficiency, with which a photodetector detects light emitted by the scintillator, in constituting the radiation detector.

### Means for solving the problems:

The present inventors conducted studies on various combinations of scintillators and optical wavelength conversion layers composed of organic fluorescent substances in an attempt to solve the aforementioned problems. As a result, they have found that a radiation detector improved in the detection efficiency of a photodetector and excellent in time resolution and count rate characteristics is obtained by using a scintillatorcomposedof anon-hygroscopic fluoride crystal with a short fluorescence lifetime, and forming between the scintillator and the photodetector an optical wavelength conversion layer composed of an organic fluorescent substance which converts light with a peak wavelength of 360 nm or less emitted by the scintillator into light with a peak wavelength of 400 nm or more. They have also found that such a radiation detector has excellent long-term operational stability. These findings have led them to accomplish the present invention.

That is, according to the present invention, there is provided a radiation detector having an optical wavelength conversion layer formed between a scintillator composed of a fluoride single crystal and a photodetector, the optical wavelength conversion layer being composed of an organic fluorescent substance, wherein the peak wavelength of light emitted by the scintillator is 360 nm or less, and the peak wavelength of light after conversion by the optical conversion layer is 400 nm or more.

In the invention of the above radiation detector, it is preferred that
1) the refractive indexes of the scintillator and the optical wavelength conversion layer be both 1.35 to 1.65;
2) the optical wavelength conversion layer be composed of the organic fluorescent substance using polyvinyltoluene as a base material;
3) the scintillator be composed of a fluoride crystal containing at least one element selected from Ce, Pr and Nd;
4) the scintillator be composed of a LiAEF₆ crystal (where A represents at least one element selected from Mg, Ca, Sr and Ba, and B represents at least one element selected from A1 and Ga) containing at least one element included among Ce, Pr and Nd;
5) the scintillator be composed of a Ce-containing Lica₁₋ₓSrₓAlF₆ crystal (where x denotes a numerical value of 0 to 1); and
6) the material for a light entrance window of the photodetector be borosilicate glass.
It is particularly preferred that the refractive indexes of the scintillator and the optical wavelength conversion layer be both 1.35 to 1.65; the material for a light entrance window of the photodetector be borosilicate glass; the optical wavelength conversion layer be composed of the organic fluorescent substance usingpolyvinyltoluene as abase material; and the scintillator be composed of a Ce-containing LiCa₁₋ₓSrₓAlF₆ crystal (where x denotes a numerical value of 0 to 1).

### Effects of the invention:

According to the present invention, a radiation detector excellent in time resolution and count rate characteristics is provided. This radiation detector has long-term operational stability, and can be used preferably in medical fields such as tomography, industrial fields such as nondestructive inspection, security fields such as inspection of personal belongings, and academic fields such as high energy physics.

### Brief Description of the Drawings:

[Fig. 1] is a conceptual drawing of a radiation detector according to the present invention.
[Fig. 2] shows the light emission spectrum of light emitted from a Ce-containing LiCaAlF₆ crystal and the light emission spectrum of light converted from the above light by an optical wavelength conversion layer composed of BC-499-09.
[Fig. 3] shows pulse height spectra obtained in Example 1 and Comparative Example 1.

### Mode for Carrying Out the Invention:

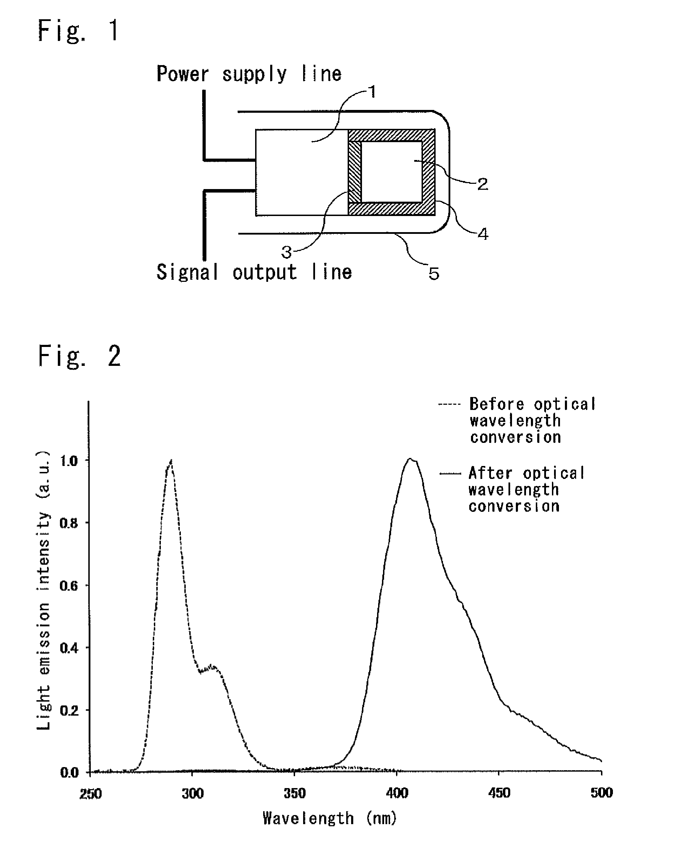

The radiation detector of the present invention is constituted by a scintillator 2 comprising a fluoride crystal, an optical wavelength conversion layer 3 comprising an organic fluorescent substance, and a photodetector 1, as shown in Fig. 1. In the radiation detector, light with a peak wavelength of 360 nm or less emitted from the scintillator 2 composed of a fluoride crystal is converted into light with a peak wavelength of 400 nm or more by the optical wavelength conversion layer 3 composed of an organic fluorescent substance. Such light with a peak wavelength of 400 nm or more is detected by the photodetector 1 with high efficiency.

In the present invention, the scintillator may be any fluoride crystal emitting light with a peak wavelength of 360 nm or less, with no limitations being imposed thereon, and a fluoride crystal hitherto known publicly can be used. The fluoride crystal has a short fluorescence lifetime, is non-hygroscopic, and excels in chemical stability.
Of the fluoride crystals, a fluoride crystal containing at least one light emitting element among Ce, Pr and Nd is preferred. The fluoride crystal containing the element can be used preferably, because it exhibits light emission with a short fluorescence lifetime based on the 5d-4f transition of this element. The fluorescence lifetimes of the fluoride crystals containing Ce, Pr and Nd differ according to the type of the fluoride crystal, and they are about 20 to 80 nsec, about 10 to 40 nsec, and about 10 to 30 nsec, respectively.
Such a fluorescence lifetime is particularly short among those of the publicly known scintillators. The use of the scintillator with such a short fluorescence lifetime makes it possible to obtain a radiation detector excellent in time resolution and count rate characteristics.

On the other hand, the peak wavelengths of light emissions from the fluoride crystals containing Ce, Pr and Nd are different according to the type of the fluoride crystal, and they are about 300 nm, about 250 nm and about 180 nm, respectively. Since the peak wavelength of light emission is short as noted above, it cannot be efficiently detected by an ordinary photodetector. However, a detection efficiency for light with such a short peak wavelength can be improved dramatically by using an optical wavelength conversion layer comprising an organic fluorescent substance which will be described later.

As the fluoride crystal, it is particularly preferred to use a LiABF₆ crystal (A represents at least one element selected from Mg, Ca, Sr and Ba, and B represents at least one element selected from Al and Ga) containing at least one light emitting element among Ce, Pr and Nd. The LiABF₆ crystal has high light emission intensity in addition to a short fluorescence lifetime. Moreover, it can be easily prepared as a large crystal. Thus, it is also excellent in terms of industrial productivity.
Furthermore, in the light of fluorescence lifetime, light emission intensity, chemical stability and productivity, a Ce-containing LiCa₁₋ₓSrₓAlF₆ crystal (x denotes a numerical value of 0 to 1) is the most preferred. In the crystal, the content of Ce is not limited, but is preferably in the range of 0.005 to 5 mols with respect to 100 mols of a Lica₁₋ₓSrₓAlF₆ crystal. Generally, the higher the content of Ce, the higher the light emission intensity becomes. If this content is too high, however, the light emission intensity has a possibility to decrease owing to concentration quenching.

In the present invention, the method of producing the scintillator composed of a fluoride crystal is not limited, and the crystal can be produced by a publicly known method for crystal production.
Concretely, the Czochralski method or the micro-pulling-down method is preferably adopted, and a fluoride crystal excellent in quality such as transparency can be produced. According to the micro-pulling-down method, moreover, the crystal can be directly produced in a specific shape and in a short time. According to the Czochralski method, on the other hand, a large crystal several inches in diameter can be produced at a low cost.

In the present invention, as the optical wavelength conversion layer comprising an organic fluorescent substance, any optical wavelength conversion layer capable of converting light with a peak wavelength of 360 nm or less emitted from the fluoride crystal into light with a peak wavelength of 400 nm or more can be used without limitation.
Of the optical wavelength conversion layers, an optical wavelength conversion layer using polyvinyltoluene as a base material is particularly preferred in view of chemical stability. The optical wavelength conversion layer particularly excelling in the efficiency of optical wavelength conversion and in chemical stability is concretely exemplified by BC-499-09, BC-400, BC-404, BC-408, BC-412, and BC-416 produced by Bicron. These exemplary optical wavelength conversion layers are commercially available as sheet - shaped products of various sizes, and they are easily obtainable.

In the present invention, the scintillator and the optical wavelength conversion layer, both having refractive indexes closer to each other, are more preferred, because a loss in light due to reflection when light emitted by the scintillator is incident on the optical wavelength conversion layer can be decreased. Moreover, the optical wavelength conversion layer and a light entrance window of the photodetector, both having refractive indexes closer to each other, are more preferred, because a loss in light can be reduced similarly.
The common material for the light entrance window of the photo detector is borosilicate glass, and its refractive index is about 1.5. In consideration of these facts, it is particularly preferred that the refractive indexes of the scintillator and the optical wavelength conversion layer be both 1.35 to 1.65.
The refractive indexes of the LiCa₁₋ₓSrₓAlF₆ crystal and the organic fluorescent substance using polyvinyltoluene as the base material, which have been mentioned as the preferred examples of the scintillator and the optical wavelength conversion layer, are 1.40 to 1.42 and about 1.58, respectively. Thus, this crystal and this organic fluorescent substance are preferred from the viewpoint of refractive index as well.

In the present invention, there are no limitations on the photodetector, and a photodetector such as a photomultiplier tube or a silicon photodiode, which has been known publicly, can be selected as appropriate and used.
Specifically, the photomultiplier tubes R6231, R7600U series, and H7416, for example, produced by HAMAMATSU PHOTONICS K.K., can be used preferably. These exemplary photodetectors are all used widely and commonly, and their detection efficiency is the highest for light with a wavelength of about 400 nm. They are each equipped with a light entrance window comprising borosilicate glass.

Preferredembodiments for the construction of a radiation detector with the use of the scintillator composed of the fluoride crystal, the optical wavelength conversion layer composed of the organic fluorescent substance, and the photodetector will be illustrated below.
The scintillator and the optical wavelength conversion layer, and the optical wavelength conversion layer and the light entrance window of the photodetector are preferably positioned close to each other, and are particularly preferably bonded to each other via an optical grease. Their close positioning enables light to be propagated efficiently from the scintillator to the optical wavelength conversion layer and from the optical wavelength conversion layer to the photodetector. By bonding via the optical grease, moreover, it becomes possible to decrease a loss of light due to its reflection at the interface between the scintillator and the optical wavelength conversion layer and between the optical wavelength conversion layer and the light entrance window of the photodetector.

The optical wavelength conversion layer may be formed directly on the surface of the scintillator. In this case, the preferred method comprises dissolving or dispersing an organic fluorescent substance in a suitable organic solvent to prepare a coating material, applying the coating material to the surface of the scintillator, and then drying the applied coating to form an optical wavelength conversion layer.
Surfaces of the scintillator and the optical wavelength conversion layer, other than their surfaces in contact with the light entrance window of the photodetector, are preferably covered with a reflector. Covering with the reflector can reduce light dissipated into parts other than the light entrance window, so that the intensity of an output signal from the radiation detector is increased. As the reflector, publicly known reflectors can be used without limitation. For example, a reflector comprising polytetrafluoroethylene or barium sulfate is preferred.

### Examples:

Herein below, the present invention will be described concretely by reference to its Examples, but the present invention is in no way limited by these Examples. Moreover, not all of combinations of the features described in the Examples are essential to the means for solution to problems that the present invention adopts.

### Example 1

### [Preparation of scintillator composed of fluoride crystal]

A Ce-containing LiCaAlF₆ crystal was prepared using a crystal preparation apparatus by the Czochralski method.
High purity fluoride powders of LiF, CaF₂, A1F₃ and CeF₃, each having purity of 99.99% or more, were used as raw materials. A crucible, a heater, and a heat insulator used were formed of high purity carbon. First, 278.4 g of LiF, 811.8 g of CaF₂, 916.8 g of AlF₃, and 61. 5 g of CeF₃ were weighed, and mixed together thoroughly. The resulting material mixture was charged into the crucible. The crucible charged with the materials was installed on a movable stage, whereafter the heater and the heat insulator were sequentially installed around the crucible.
Then, a LiCaAlF₆ single crystal, which had been cut, ground and polished in the form of a rectangular parallelepiped measuring 6×6×30 mm³, with the 30 mm side extending along the c-axis direction, was used as a seed crystal, and mounted on the front edge of an automatic diameter control device. Then, the interior of a chamber was evacuated under vacuum to 5.0 ×10⁻⁴ Pa by use of a vacuum evacuation device composed of an oil-sealed rotary vacuum pump and an oil diffusion pump. Then, a tetrafluoromethane-argon mixed gas was introduced into the chamber up to atmospheric pressure for gas exchange.

A high frequency current was applied to a high frequency coil to heat the materials by induction heating, thereby melting them. The seed crystal was moved and brought into contact with the liquid surface of the molten material melt. The output of the heater was adjusted such that a portion of the melt in contact with the seed crystal reached a solidification temperature. Then, under control by the automatic diameter control device, the resulting crystal was pulled upward, with the pull rate being automatically adjusted so as to achieve a diameter of 55 mm.
During crystal growth, the movable stage was moved, as appropriate, in order to adjust the liquid level to a constant position, and the crystal was continuously pulled up, with the output of the high frequency coil being adjusted where appropriate. When the crystal grew to a length of about 80 mm, the crystal was cut off the liquid surface, and cooled over about 48 hours to obtain a Ce-Containing LiCaAlF₆ crystal with a diameter of 55 mm and a length of about 80 mm.
The resulting crystal was cut by a wire saw provided with a diamond wire, and ground and optically polished to be processed into a shape having a 10 mm square plane of incidence of radiation and having a thickness of 2 mm in the direction of incidence of radiation, whereby a scintillator used in the present invention was obtained. The refractive index of the resulting Ce-containing LiCaAlF₆ crystal was 1.40.

### [Measurement of light emission spectra before and after optical wavelength conversion of light from scintillator]

²⁴¹Am having radioactivity of 4 MBq was placed nearby the scintillator, and the scintillator was irradiated with α-rays emitted from the ²⁴¹Am. Light generated by the scintillator upon incidence of the α-rays was measured with a spectrophotometer to obtain the light emission spectrum of the scintillator. In the light emission spectrum of the scintillator, the peak wavelength was 290 nm.
Then, an optical wavelength conversion layer was bonded to the scintillator with the use of an optical grease. The optical wavelength conversion layer used was BC-499-09 produced by Bicron which was an organic fluorescent substance having a refractive index of 1.58 and using polyvinyltoluene as its base material. Similarly to the above procedure, the scintillator was irradiated with α-rays, and light generated by the scintillator was subjected to wavelength conversion by the optical wavelength conversion layer. The resulting converted light was measured with a spectrophotometer to obtain the light emission spectrum of the light after optical wavelength conversion. In the light emission spectrum after optical wavelength conversion, the peak wavelength was 410 nm.

### [Production of radiation detector]

A radiation detector of a structure as shown in Fig. 1 was produced. The optical wavelength conversion layer (BC-499-09; 10 mm square, 100 µm thick) was bonded to a light entrance window of a photodetector with the use of an optical grease. A photomultiplier tube (R6231) produced by HAMAMATSU PHOTONICS K.K. was used as the photodetector. This photodetector has borosilicate glass as the light entrance window, and shows maximum detection efficiency for light with a wavelength of 400 nm.
Then, a surface of the scintillator opposite to its plane of radiation incidence was bonded to the optical wavelength conversion layer with the use of an optical grease. Then, the scintillator and the optical wavelength conversion layer were covered with a reflector to obtain a radiation detector according to the present invention.

The response characteristics of the radiation detector to radiation were measured in the following manner:
²⁴¹Am having radioactivity of 4 MBq was placed nearby the scintillator, and a light shielding sheet was applied to the system so as to block light entering from the outside, under irradiation with α,-rays . In order to measure light emitted from the scintillator and converted by the optical wavelength conversion layer (this light will be referred to hereinafter as output light), a high voltage of 800 V was applied to the photomultiplier tube to convert the output light into electrical signals. The electrical signals outputted from the photomultiplier tube are pulsed signals reflecting the output light, and the pulse height of the pulsed signal represents the intensity of the output light. The waveform of the pulsed signal draws a decay curve based on the fluorescence lifetime of the output light.
Analysis of the decay curve showed that the fluorescence lifetimewas40nsec. Thus, the radiation detector of the present invention was found to be excellent in time resolution and count rate characteristics.

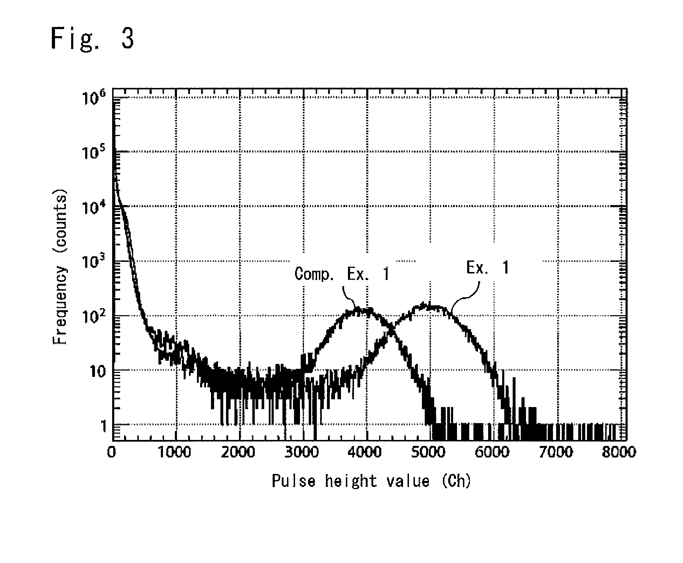

Then, the electrical signals outputted from the photomultiplier tube were shaped and amplified by a shaping amplifier, and then entered into a multichannel pulse height analyzer to analyze them and prepare a pulse height spectrum.
The pulse height spectrum obtained in the radiation detector of Example 1 is shown in Fig. 3. The abscissa of the pulse height spectrum represents the pulse height value of the electrical signal, namely, the intensity of output light, which was indicated by the channel number of the multichannel pulse height analyzer. The ordinate represents the frequency of the electrical signal showing each pulse height value, which was expressed as the number of times (counts) the relevant electrical signal was measured.
As seen from Fig. 3, the radiation detector of the present invention can clearly detect the incidence of radiation as an electrical signal. Moreover, the response characteristics of the radiation detector in response to radiation were measured at intervals of one month. Even after a lapse of one year, response characteristics similar to those mentioned above were obtained without deterioration over time, demonstrating that the radiation detector of the present invention has long-term stability.

### Comparative Example 1

### [Production of radiation detector]

A radiation detector was produced in the same manner as in Example 1, except that the optical wavelength conversion layer was not installed. That is, the surface of the scintillator opposite to its plane of incidence of radiation was bonded to the light entrance window of the photodetector with the use of the optical grease. Then, the scintillator was covered with the reflector to construct a radiation detector.
The response characteristics of the radiation detector in response to radiation were measured in the same manner as in Example 1. Pulsed electrical signals outputted from the photomultiplier tube were analyzed, and the fluorescence lifetime was found to be 40 nsec. The resulting pulse height spectrum is shown in Fig. 3. Comparisons of the fluorescence lifetimes and the pulse height spectra in Example 1 and Comparative Example 1 show that the radiation detector of the present invention can increase the intensity of output signals while maintaining the shortness of the fluorescence lifetime inherent in the scintillator.

### Explanations of Letters or Numerals:

| | |
|---|---|
| 1 | Photomultiplier tube |
| 2 | Scintillator |
| 3 | Optical wavelength conversion layer |
| 4 | Reflector |
| 5 | Light shielding sheet |

## Claims

1. A radiation detector having an optical wavelength conversion layer formed between a scintillator composed of a fluoride crystal and a photodetector, the optical wavelength conversion layer being composed of an organic fluorescent substance, wherein a peak wavelength of light emitted by the scintillator is 360 nm or less, and a peak wavelength of light after conversion by the optical conversion layer is 400 nm or more.

2. The radiation detector according to claim 1, wherein refractive indexes of the scintillator and the optical wavelength conversion layer are both 1.35 to 1.65.

3. The radiation detector according to claim 1, wherein the optical wavelength conversion layer is composed of the organic fluorescent substance using polyvinyltoluene as a base material.

4. The radiation detector according to claim 1, wherein the scintillator is composed of a fluoride crystal containing at least one element selected from Ce, Pr and Nd.

5. The radiation detector according to claim 4, wherein the scintillator is composed of a LiABF₆ crystal (where A represents at least one element selected from Mg, Ca, Sr and Ba, and B represents at least one element selected from A1 and Ga) containing the at least one element included among Ce, Pr and Nd.

6. The radiation detector according to claim 5, wherein the scintillator is composed of a Ce-containing LiCa₁₋ₓSrₓAlF₆ crystal (where x denotes a numerical value of 0 to 1).
